Europäisches Patentamt

European Patent Office

Office européen des brevets

(11) Publication number: **0 519 352 A2**

# EUROPEAN PATENT APPLICATION

(21) Application number: **92109955.2**

(22) Date of filing: **12.06.92**

(51) Int. Cl.5: **H01L 23/485**, H01L 21/90

(30) Priority: **14.06.91 JP 192420/91**

(43) Date of publication of application:
**23.12.92 Bulletin 92/52**

(84) Designated Contracting States:
**DE FR GB**

(71) Applicant: **CANON KABUSHIKI KAISHA**
**30-2, 3-chome, Shimomaruko, Ohta-ku**
**Tokyo(JP)**

(72) Inventor: **Akino, Yutaka, c/o Canon Kabushiki**
**Kaisha**
**30-2, 3-chome, Shimomaruko**
**Ohta-ku, Tokyo 146(JP)**

(74) Representative: **Bühling, Gerhard, Dipl.-Chem.**
**et al**
**Patentanwaltsbüro Tiedtke-Bühling-Kinne &**
**Partner, Bavariaring 4**
**W-8000 München 2(DE)**

(54) Semiconductor device provided with contact through a thick insulating film.

(57) A semiconductor device is provided with a main electrode area of the semiconductor device partially under a thick insulating film (4) formed on the substrate (1). A part of said main electrode area and the wiring are mutually connected electrically through a hole penetrating said thick insulating film on a part of said main electrode area.

F I G. I

Rank Xerox (UK) Business Services

# BACKGROUND OF THE INVENTION

## Field of the Invention

The present invention relates to a semiconductor device used for various electronic apparatuses. More particularly, the invention relates to transistors and other semiconductor devices which require an electrical contact between the semiconductor areas under a thick insulating film and a wiring metallic film.

## Related Background Art

In the conventional semiconductor devices, when the respective semiconductor areas are connected by conductor with each other, the wiring material and substrate are in contact in the active area thereof. Therefore, in a case of a filed effective transistor, the source and drain areas and others constituting the main electrode semiconductor area (which is a term given to a semiconductor area which functions as source, drain, and others) are formed in the active area.

Also, there has been designed a transistor of such a structure that its source and drain are partially provided under a thick oxdiation film. One example, which is disclosed in the specification of Japanese Patent Publication No. 59-7230, is structured with a buried metallic layer.

In the prior art described earlier, the contact between the metallic wirings and the source and drain areas is arranged in its active area. Therefore, it is necessary to make the source and drain areas wide because a hole should be provided for their contact with the wirings. Moreover, the margin for manufacturing process should be prepared in addition thereto, and the area which is occupied by them is larger than the actual effective area. Thus creating a problem that the element area becomes great after all.

Also, when an element has a complicated stepping configuration due to the provision of a thick oxidation film, it is necessary to prepare a film which is thicker than a certain thickness in order to form evenly the Al film which serves as metallic wirings without any disconnection on the uneven surface. This creates a problem that the stepping surface of the element (unevenness) becomes more conspicuous.

In smoothing the stepping surface (unevenness), it may be possible to make a slight improvement by widening the active area of the transistor. However, this results in a larger size of the element, hindering the miniaturization thereof. Also, the oxidation firm and others may be made thinner to minimize the surface unevenness. However, there is also problem that it is not desirable in consideration of the reliability of the element.

As described above, in the conventional transistors, it is a great obstacle from the viewpoint of the miniaturization and reliability that the contact is made with the wiring materials and others in the active area.

# SUMMARY OF THE INVENTION

It is an object of the present invention to enhance the miniaturization of semiconductor devices, and improve the surface smoothness, the film thickness, and the reliability by forming the electrical contact between the main electrode semiconductor area, the source, drain, and others, and the wiring material through the contact hole provided penetrating thick insulating film on the peripheral portion of the element outside the area surrounded by the thick insulating film on a transistor or other semiconductor devices.

Also, it is another object of the present invention to provide a method for manufacturing semiconductor devices capable of forming a fine element by providing contact with its substrate from the outside of the area surrounded by the thick insulating film on a semiconductor device with an application of a selective CVD technique.

It is still another object of the present invention to provide a semiconductor device as means to solve the aforesaid problems in the semiconductor device having its impurity area under the thick insulating film formed selectively on the substrate, which is characterized in that there is provided an electrical contact between the aforesaid impurity area and the metallic layer arranged for wirings through the hole penetrating the aforesaid thick insulating film portion immediately above the aforesaid impurity area.

Also, in the aforesaid method for manufacturing semiconductor devices, there is preferably used a method for manufacturing semiconductor devices characterized in that a contact hole is opened in the thick insulating film immediately above the impurity area, and the aforesaid contact hole is filled flat with a wiring metal by a selective deposition, and that subsequent thereto, the wiring metal is formed all over by a non-selective deposition to form a wiring pattern.

According to the present invention, it is possible to make the active portion of a semiconductor element smaller by effectuating the contact between the wiring material and the semiconductor electrode area outside the area surrounded by the thick insulating film on the semiconductor device.

Further, it is possible to make the wiring material thinner by filling the opening portion selectively for the wiring. Then, such portion being formed flat but with comparatively small irregularity, it is possible to achieve making the wiring material finer simultaneously.

## BRIEF DESCRIPTION OF THE DRAWINGS

Fig. 1 is a cross-sectional view schematically showing a semiconductor device according to an embodiment of the present invention.

Fig. 2 is a cross-sectional view schematically showing a semiconductor device according to another embodiment of the Present invention.

Figs. 3A to 3C are schematic views illustrating a method for manufacturing a semiconductor according to an embodiment of the present invention.

Fig. 4 is a block diagram showing a system using a semiconductor device according to the present invention.

## DETAILED DESCRIPTION OF THE PREFERRED EMBODIMENTS

A preferred embodiment according to the present invention is a semiconductor device in which while a channel area, base area, and the like which constitute a main operational area of the semiconductor device are formed in a small semiconductor area surrounded by a comparatively thick insulating film, a contact between the main electrode semiconductor area such as source and drain or collector and emitter and the wiring (electrode) is formed under the aforesaid thick insulating film.

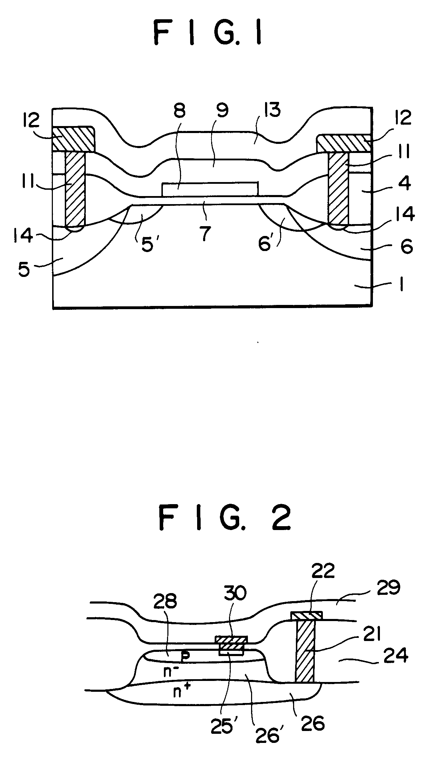

Fig. 1 is a view showing an embodiment according to the present invention. A semiconductor substrate 1 is provided with a thick insulating film 4, source and drain areas (5 and 6) arranged thereunder, and source and drain areas (5' and 6') in an area surrounded by the thick insulating film 4. Between these areas (5' and 6'), a channel area is formed. On the channel area, a gate insulating film 7 and gate electrode 8 are arranged. Then, the contact between the source and drain is formed at 14 under the comparatively flat portion of the thick insulating film 4 but not in the narrow portions (5' and 6').

Fig. 2 is a view showing another embodiment according to the present invention, in which a reference numeral 26 designates a collector filling area; 26', a high resistive area formed by an epitaxial deposition; 28, a base area; and 25', an epitaxial area.

Under the thick insulating film 24, the collector filling area 26 is partially present, and a collector electrode 21 is provided through this insulating film 24.

A reference numeral 22 designates a collector wiring; 30, an emitter wiring; and 29, a protective layer.

The thick insulating film used for the present invention can be an insulating film if only it is thicker than the gate insulating film which is formed in the main active area surrounded by a thick insulating film in all directions. It is preferable, however, that the thickness of such a film is sufficient so that the conductive type of the semiconductor area provided thereunder is not inverted by a voltage applied to the wiring arranged immediately above the thick insulating film.

More specifically, the thickness should be 3,000 Å to 10,000 Å, and more preferably, 3,500 Å to 8,500 Å.

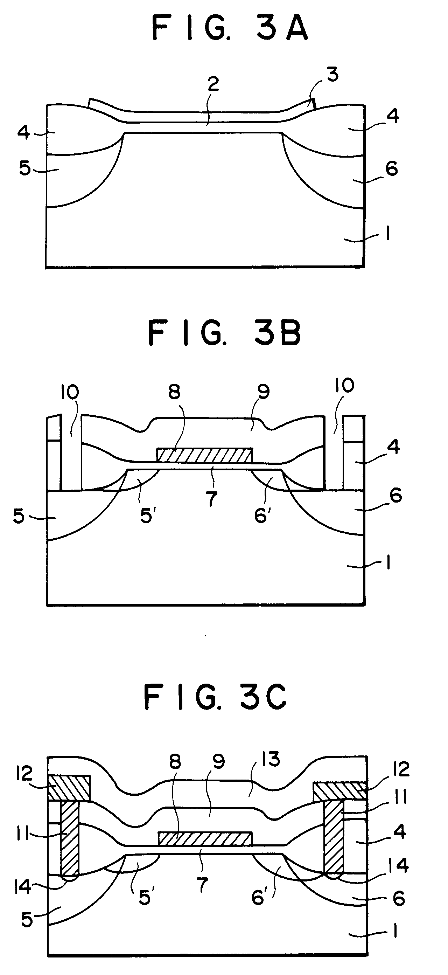

Fig. 3A to Fig. 3C are views illustrating the manufacturing processes of a field effect transistor and its cross-sectional structure as a semiconductor device according to the present invention. Hereinafter, in conjunction with Figs. 3A to 3C, the processes will be described.

In Figs. 3A to 3C, at first, p-type monocrystal Si (100) 1 is used for the semiconductor substrate. After cleaning this substrate sufficiently, an $SiO_2$ film 2 is formed by a thermal oxidation method for 350 Å, and on the film, a covering film serving as a mask against impurity and oxidation gas, such as SiN film 3, is deposited by a decompressed CVD method for 1,000 Å.

Dry etching is given by $CF_4$ or other fluorine gas, for example, to this SiN film 3 with the resist formed in a desired pattern as a mask (Fig. 3A).

Then, an ion injection of As ion is performed with this SiN film 3 as a mask so that As ion is injected into the Si substrate as impurity.

Here, if a channel stop function is needed on the outer area of the element, it will suffice if only $B^+$ or $BF_2^+$ ion is injected with the required alignment of mask.

Subsequently, a thermal oxidation is given to this substrate in an oxidation gas for 8,000 Å. Then, the SiN film 3 which has served as mask in oxidation is removed in a solution of thermo-phosphoric acid. In this way, the areas other than the main active area of the transistor are covered with a thick oxidation film 4, and the areas serving as the source 5 and drain 6 are placed under the thick oxidation film 4 with the exception of their parts which have dispersed in the lateral direction.

After the $SiO_2$ film 2 oxidized at first has been removed by etching, the substrate surface is cleaned sufficiently, and a gate oxidation is performed for 350 Å to obtain the gate oxidation film 7.

Subsequently, a polycrystalline silicon is deposited by the decompressed CVD method for 4,000 Å to form the pattern of the gate electrode 8. Then, the implantation of $As^+$ (5' and 6') is performed to give self-alignment to the gate, and source and drain.

Further, an inter-layer insulating film 9 is deposited thereon by a normal CVD method for 8,000 Å, and a hole 10 is opened by dry etching with a resist as a mask for connecting the source 5 and drain 6 and the metallic wiring material so that the surfaces of the source 5 and drain 6 are exposed (Fig. 3B).

Then, the substrate is placed in a CVD reaction chamber where an exhaust is conducted to a state of $1 \times 10^{-8}$ Torr, and DMAH (dimethyl aluminum hydride) which uses hydrogen gas as a carrier gas and $Si_2H_6$ are supplied.

Further, as a reaction gas, $H_2$ is flown to make the inner pressure of the reaction chamber 1.5 Torr. The partial pressure of the DMAH at this juncture is $1.5 \times 10^{-4}$ Torr, and the partial pressure of the $Si_2H_6$ is $2 \times 10^{-6}$ Torr.

After that, the lump is illuminated to heat the wafer directly to 270°C. Thus, the hole 10 on the source and drain is filled with Al-Si.

When the film thickness of the filled Al-Si film has become the same height of the upper part of the inter-layer insulating film 9, the deposition is suspended.

Then, the exhaust is conducted to a state of $5 \times 10^{-6}$ Torr, and by opening the gate valve the wafer is transported in a vacuum to a sputtering chamber where an exhaust is also conducted to a state of $5 \times 10^{-6}$ in a vacuum.

After the sputtering chamber is conditioned to a state of $3.5 \times 10^{-3}$ Torr in an atmosphere of argon gas, the wafer holder is heated to 250°C, and a discharging is conducted with a DC 7KW power to strike the Al-Si target with argon ion for the deposition of the Al-Si film 12 on the substrate by sputtering.

When the wafer is exposed to the air once subsequent to the hole 10 having been filled, an RF etching of argon ion should be conducted before the Al-Si sputtering deposition, and it is necessary to remove the oxidation of the Al-Si CVD film for approximately 100 Å.

Then, the Al-Si sputtering film is machined to obtain a desired pattern. For the wiring material thus prepared, the protection film 13 is formed and the hole for the external contact is opened.

In order to make the contact with the source 5 and drain 6 under the thick oxidation film 4 excellent, it may be possible to inject $P^+$ or $As^+$ ion (at 14 in Fig. 3C).

As described above, according to the present invention, it is possible to obtain the effect to make the semiconductor device small as well as to improve the flatness and reliability thereof by enabling the impurity area and the metallic film provided for wiring to be electrically contacted through the hole opened in the thick oxidation film arranged immediately above the impurity area such as source and drain of the transistor.

The majority of the source and drain areas of a transistor, for example, can be provided under a thick oxidation film, and the contact with a metallic wiring material is arranged in such a portion thereby to make the main active area of the transistor small. Hence obtaining the effect to miniaturize the element.

Also, there is no need for the provision of any wiring in the main active area of an element where the conspicuous irregularity of surface is present, and the patterning can be conducted on a flat portion. Thus, it becomes unnecessary to make the thickness of a film excessively thick. This leads advantageously to the miniaturization of the element.

Also, using a semiconductor device according to the present invention, which is finer than the conventional ones, it is possible to attain a higher integration of circuits. Hence enabling the enhancement of the performance of the electronic equipment and devices which will be more compact with higher efficiency in the future.

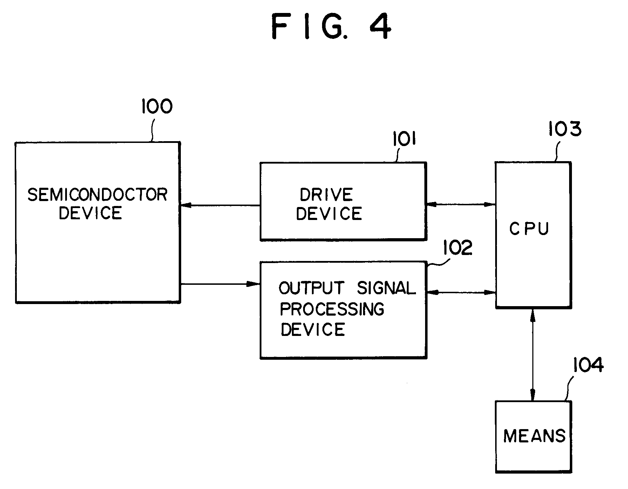

Fig. 4 is a schematic view showing an example of the applied system to a semiconductor device according to the present invention, in which a reference numeral 100 designates the semiconductor of the present invention.

Now, by an instruction form a CPU 103, for example, a driving unit 101 is driven to operate the semiconductor device 100. The signals thus obtained are processed by a output signal processing unit 102 and output to the CPU 103. On the basis of the result thereof, a certain means 104 is driven. This means 104 can be an ink jet recording head, thermal head, electromagnetic head, or the like for a recording apparatus, or an image sensor for inputting images or some others.

Many numbers of semiconductor devices according to the present invention are installed in the CPU 103, driving unit 101, output signal processing unit 102 as well as in means 104 as a matter of course.

A semiconductor device is provided with a main electrode area of the semiconductor device partially under a thick insulating film formed on the substrate. A part of said main electrode area and the wiring are mutually connected electrically through a hole penetrating said thick insulating film on a part of said main electrode area.

## Claims

1. A semiconductor device having a main electrode area of the semiconductor device partially under a thick insulating film formed on the substrate, characterized in that

   a part of said main electrode area and the wiring are connected electrically through a hole penetrating said thick insulating film on a part of said main electrode area.

2.   A semiconductor device according to Claim 1, wherein
said main electrode area is the collector of a bipolar transistor.

3.   A semiconductor device according to Claim 1, wherein
said main electrode area is the source and drain areas which constitute a field effect transistor.

# F I G. I

# F I G. 2

# F I G. 3A

# F I G. 3B

# F I G. 3C

# F I G. 4